# EUROPÄISCHE PATENTSCHRIFT

(11) **EP 2 432 125 B1**
(45) Veröffentlichungstag und Bekanntmachung des Hinweises auf die Patenterteilung: **11.03.2015**
(21) Anmeldenummer: 11009826.6
(22) Anmeldetag: 10.01.2006
(51) Int. Cl.: H03K 17/95, H03B 5/04, H03L 1/02

(54) **Näherungsschalter und Verfahren zum Betrieb eines Näherungsschalters**
Proximity switch and method of operating a proximity switch
Commutateur de proximité et procédé de fonctionnement d'un commutateur de proximité

(30) Priorität: 13.01.2005 DE 102005001692
(43) Veröffentlichungstag der Anmeldung: 21.03.2012
(62) Teilanmeldung aus: 06706187.9
(73) Patentinhaber: Pepperl & Fuchs GmbH, 68307 Mannheim (DE)
(72) Erfinder: Kühn, Thomas, 68219 Mannheim (DE)
(74) Vertreter: Schiffer, Axel Martin

(56) Entgegenhaltungen:
- EP-A- 0 070 796
- EP-A- 0 319 470
- DE-A1- 3 931 892
- US-B1- 6 259 333
- DELIYANNIS, THEODORE L. ET. AL: "Continuous-Time Active Filter Design", 1999, CRC PRESS LLC, BOCA RATON, XP002384932, * Chapter 3.6 - 3.6.6 * * Abbildungen 3.22,3.23 *

## Beschreibung

Die vorliegende Erfindung betrifft einen Näherungsschalter, insbesondere einen induktiven Näherungsschalter, nach dem Oberbegriff des Anspruchs 1 sowie ein Verfahren zum Betrieb eines, insbesondere induktiven, Näherungsschalters nach dem Oberbegriff des Anspruchs 14.

Ein gattungsgemäßer Näherungsschalter weist einen Oszillator mit einem durch ein zu detektierendes Target beeinflussbaren, wenigstens teilweise eigenkompensierten Rückkopplungsnetzwerk und mit einem Oszillatorverstärker auf.

Als Messgröße dient bei Näherungsschaltern im Allgemeinen eine Änderung der Resonanzimpedanz des Schwingkreises bei Annäherung des zu überwachenden Targets an den Näherungsschalter.

Da diese Änderungen der Resonanzimpedanz vergleichsweise klein sind, können hierbei bisher nur geringe Schaltabstände erzielt werden. Beispielsweise ändert sich bei der Bauform "M 18, shielded" die Resonanzimpedanz bei Annäherung des Targets aus großer Entfernung nur noch um etwa 0,3 %, wenn zum Dreifachen des Normschaltabstands übergegangen wird. Demgegenüber beträgt bei dieser Bauform die Änderung bei Annäherung bis zum Normschaltabstand immerhin ca. 30 % der Resonanzimpedanz.

Die Größe der beobachteten Änderung der Resonanzimpedanz ist für den maximal erzielbaren Schaltabstand begrenzend, da die Temperaturabhängigkeiten der relevanten physikalischen Eigenschaften der eingesetzten Komponenten zu erheblichen, nicht vernachlässigbaren Änderungen der Resonanzimpedanz führen. Aus diesem Grund sind bisher nur vergleichsweise kleine Schaltabstände realisierbar, wobei die Schaltabstände grundsätzlich von der Bauform abhängen.

Hierbei spielen Bauteile-Toleranzen, insbesondere elektrische und mechanische Absolut-Toleranzen sowie Fertigungs-Toleran-zen, d.h. relative Toleranzen, eine Rolle. Abweichungen ergeben sich außerdem durch die Abhängigkeit elektrischer Parameter von den Fertigungs-Toleranzen, beispielsweise von z.B. Positionierungstoleranzen der Wicklung relativ zum Kern.

Beachtet werden muss außerdem die Qualität der verwendeten Komponenten. Beispielsweise kann es aufgrund der Alterung von Bauteilen und Stoffen zu Driften elektrischer Parameter kommen. Schließlich können Alterungsprozesse auch eventuelle Verbindungen, beispielsweise Fügungen, verändern und/oder verschlechtern, was wiederum zu Änderungen bzw. Driften der relevanten elektrischen Parameter führt. Beispielsweise kann es in der elektronischen Schaltung zu Ablösungen kommen und es können Stoffe aus der Umgebung resorbiert werden.

Zwar wurde bereits eine Reihe von Maßnahmen vorgeschlagen, mit denen Temperatureffekte bei Näherungsschaltern kompensiert werden können. Diese sind jedoch verfahrensmäßig und/oder schaltungstechnisch sehr aufwändig und lassen darüber hinaus auch im Hinblick auf die erzielten Resultate zu wünschen übrig. Insbesondere hat sich der hergebrachte Exemplar-Abgleich bei Raumtemperatur als unzureichend erwiesen. Weiterhin genügt es nicht, nur die Temperaturabhängigkeiten erster Ordnung zu kompensieren, da mitunter erhebliche Beiträge der zweiten und dritten Ordnung bestehen, die minimiert oder wenigstens teilweise kompensiert werden sollen. Bisher wurde hierzu beispielsweise ein NTC-Netzwerk verwendet. Weitere Verbesserungen, die jedoch jeweils mit erheblichem Aufwand verbunden sind, beinhalten eine mehrstufige oder mehrfache Kompensation bzw. einen mehrstufigen Abgleich. Darüber hinaus kann neben einem Temperaturabgleich über eine vorzusehende Schnittstelle nach Endmontage des Näherungsschalters ein Abgleich bzw. eine Kompensation erfolgen.

Bei einem konventionellen System sind höhere Schaltabstände bisher im Wesentlichen aus folgenden Gründen nicht möglich. Zunächst führen Temperaturgradienten zwischen dem Spulensystem und dem Verstärker einerseits sowie zwischen dem Spulensystem und einem eventuell vorhandenen Kompensationsnetzwerk andererseits zu Fehlern bei Temperaturwechseln. Weiterhin kann die Anpassung zwischen dem Kompensationsnetzwerk und dem Verstärker/Spulensystem nur begrenzt gut durchgeführt werden. Schließlich ist aufgrund von Parameterstreuungen und Fertigungstoleranzen sowohl der verwendeten Komponenten im Spulensystem als auch des Gesamtaufbaus nur eine begrenzte Reproduzierbarkeit erzielbar.

Bei einer aufwändigen Variante eines nur bei Raumtemperatur durchgeführten elektronischen Exemplar-Abgleichs wird ein Widerstandsnetzwerk digital eingestellt bzw. programmiert. Entsprechend können auch Steuerungsströme digital eingestellt oder programmiert werden. Eine Kommunikation kann dabei über die Versorgungsleitungen erfolgen. Ein Beispiel hierfür findet sich in DE 197 02 059 C2.

Ein besonders elegantes Verfahren zur Kompensation einer Hauptkomponente der erwähnten Temperaturabhängigkeiten, nämlich des Temperaturkoeffizienten des Kupferwiderstandes der Schwingkreisspule, ist in EP 0 070 796 angegeben. Das dort beschriebene Mitkopplungsnetzwerk, das insbesondere zwei antiserielle, induktiv gekoppelte Spulen beinhaltet, kann deshalb auch als eigenkompensiertes Mitkopplungsnetzwerk bezeichnet werden, d.h. dessen Transmission wird bei gegebener Frequenz und Bauteilparametrierung idealerweise nur noch durch die Bedämpfung der Spulen durch ein zu erkennendes Target bestimmt. Eine Weiterentwicklung der in EP 0 070 796 beschriebenen Schaltung ist in EP 0 319 470 A1 offenbart. Um Verluste mit kupferungleichem Temperaturkoeffizienten ausgleichen zu kön- nen, wird der Gegenkopplungspfad in zwei Teilpfade aufgeteilt. Der erste dieser Teilpfade weist dabei eine solche Temperaturabhängigkeit auf, dass dadurch die Schwingkreisverluste mit kupfergleichen Temperaturkoeffizienten ausgeglichen werden. Der zweite Gegenkopplungspfad,im einfachsten Fall über einen ohmschen Widerstand, ermöglicht die Kompensation des Temperaturgangs, hervorgerufen durch die Verlustanteile mit nicht kupfergleichen Temperaturkoeffizienten, feldinduzierte Verluste im Gehäuse oder Proximityverluste in der Spule.

Ein relativ aufwändiges Verfahren ist außerdem aus DE 100 46 147 bekannt. Hierbei wird durch Kommunikation über die Versorgungsleitungen ein dreistufiges Einstellverfahren durchgeführt. Zunächst werden unter Verwendung eines Summenstroms aus gewichteten Stromquellen mit verschiedenen Kennlinien typspezifische Einstellungen für die Oszillator-Kennlinie vorgenommen. Sodann wird zur Kompensation von Exemplar-Streuungen bei Raumtemperatur ein Abgleich durch Programmierung eines digitalen Widerstands-Netzwerks durchgeführt. Schließlich erfolgt außerdem zur Kompensation von Exemplar-Streuungen ein Temperaturabgleich über eine digital einstellbare Komparator-Schwel-le. Noch nicht geklärt ist wohl, inwieweit der dort beschriebene Aufbau bzw. das dort beschriebene Verfahren für eine gute Ausbeute ausreichend ist. Weiterhin handelt es sich um ein aufwändiges Verfahren, welches insbesondere eine Definition der Kennlinien erfordert. Auch der Bauelemente-Aufwand ist erheblich, beispielsweise werden zwei ASICs benötigt. Schließlich ergeben sich aufgrund der notwendigen thermischen Kopplung mechanische und bauliche Einschränkungen.

Ein induktiver Näherungsschalter zum materialunabhängigen Nachweis von metallischen Gegenständen ist in DE 201 08 904 U1 beschrieben. Um mit einfachen Mitteln einen materialunabhängigen Nachweis von Nichteisen- und ferromagnetischen Metallen zu ermöglichen, wird dort ein Näherungsschalter vorgeschlagen, bei dem die Spulenwicklung, statt wie bisher aus einem hochleitfähigen Material, nunmehr wenigstens teilweise aus einer Widerstandslegierung gefertigt ist. Eine Temperaturkompensation ist dort nicht vorgesehen.

Eine weitere Alternative zur Kompensation von Temperatureffekten ist in DE 195 27 174 A1 beschrieben. Bei dem dort offenbarten Näherungsschalter wird in Abhängigkeit eines Signals eines Temperatursensors am Oszillator die Schaltschwelle variiert.

DE 39 31 892 A1 betrifft ebenfalls einen Näherungsschalter, bei dem in Abhängigkeit eines Temperaturfühlersignals ein Modifizierkreis oder ein Diskriminator, also eine Schaltschwelle, gesteuert wird. Alternativ kann auch die Verstärkung einer dem Oszillator zugeordneten Betriebs/Messschaltung in Abhängigkeit des Temperatursignals verändert werden.

Um die Temperaturkompensation einer Schwingkreisspule gegenüber bekannten Lösungen mit einem NTC-Widerstand zu verbessern, schlägt DE 39 26 083 A1 vor, den Kern einer Schwingkreisspule als Temperaturfühler zu verwenden. In Abhängigkeit eines von diesem Temperaturfühler gelieferten Signals steuert eine linearisierte Steuereinrichtung eine Stromquelle, die in einem Emitter-Kollektor-Kreis eines Schwingkreistransistors geschaltet ist. Diese Steuerung erfolgt so, dass temperaturbedingte Änderungen des Schwingkreisstroms kompensiert werden.

Ein Detektor zum Nachweis von lebenden Körpern, bei dem ebenfalls eine Temperaturkompensation vorgesehen ist, ist Gegen-stand von EP 0 744 631 A1.

US-4,956,606 betrifft ein berührungslos arbeitendes induktives Messsystem, insbesondere zum Messen eines Spiegels eines Bads von flüssigem Aluminium. Um ein Ausgangssignal im Hinblick auf Temperaturvariationen zu kompensieren, werden dort die Messsignale von Temperatursensoren von einem Temperatur-Kompensationskreis aufgenommen und ausgewertet. Eine unmittelbare Rückwirkung dieser Temperatursignale auf die Oszillatorelektronik ist dort nicht vorgesehen.

In den Schriften DE 34 25 662 A1 und DE 196 40 677 A1 sind Varianten zur Kompensation von Temperatureffekten bei Quarzoszillatoren beschrieben.

**Aufgabe** der Erfindung ist es, einen Näherungsschalter und ein Verfahren zu dessen Betrieb zu schaffen, durch welche eine stabilere Funktion über einen großen Temperaturbereich bei erhöhten Schaltabständen erzielt wird.

Diese Aufgabe wird durch den Näherungsschalter mit den Merkmalen des Anspruchs 1 sowie durch das Verfahren mit den Merkmalen des Anspruchs 14 gelöst.

Bevorzugte Ausführungsformen des erfindungsgemäßen Näherungsschalters und vorteilhafte Varianten des erfindungsgemäßen Verfahrens sind Gegenstand der Unteransprüche.

Der Näherungsschalter der oben angegebenen Art ist erfindungsgemäß dadurch weitergebildet, dass der Oszillatorverstärker einen Verstärkerbaustein und ein steuerbares Netzwerk zum Steuern der Verstärkung des Oszillatorverstärkers aufweist, dass das steuerbare Netzwerk ein passives Kopplungsnetzwerk, insbesondere Gegenkoppelnetzwerk, und einen steuerbaren Steilheitsverstärker zum Steuern einer Übertragungsfunktion des steuerbaren Netzwerks aufweist, dass ein Temperaturfühler zur Bestimmung der Temperatur zumindest des Oszillatorverstärkers vorgesehen ist, wobei ein von einem Ausgangssignal des Temperaturfühlers abgeleitetes Signal als Steuersignal für den Steilheitsverstärker dient, und dass der Oszillatorverstärker auf Grundlage der von dem Temperaturfühler bestimmten Temperatur über den Steilheitsverstärker so steuerbar ist, dass temperaturbedingte Variationen der Oszillator-Eigenschaften zumindest teilweise kompensierbar sind

Bevorzugt ist auch der Oszillatorverstärker weitestgehend eigenkompensiert. Beispielsweise können das Rückkopplungsnetzwerk und/oder der Oszillatorverstärker zumindest linear nominal eigenkompensiert sein.

Temperaturbedingte Transmissionsvariationen des Rückkoppelnetzwerks oder des Oszillatorverstärkers können bei dem erfindungsgemäßen Näherungsschalter weitestgehend, insbesondere in erster Ordnung, kompensiert werden.

Temperaturbedingte Transmissionsvariationen des Rückkoppelnetzwerks können beispielsweise aufgrund von individuellen Unterschieden der Einbauverhältnisse des Spulensystems oder auch aufgrund von Parametersteuerungen und Fertigungstoleranzen entstehen.

Damit kann ein Oszillatorverstärker erhalten werden, der steuerbar ausgebildet ist, einen Temperaturfühler zur Bestimmung seiner Temperatur vorsieht und auf Grundlage der von dem Temperaturfühler bestimmten Temperatur so steuerbar ist, dass temperaturbedingte Transmissionsvariationen des Rückkopplungsnetzwerks, die aus den individuellen Einbauverhältnissen des Spulensystems oder Parameterstreuungen und Fertigungstoleranzen herrühren, zumindest großteils und insbesondere in linearer Näherung kompensierbar sind.

Temperaturbedingte Variationen können bei Oszillatorverstärkern, die zwar nominal eigenkompensiert sind, ebenfalls aufgrund von Parameterstreuungen innerhalb des Oszillatorverstärkers auftreten.

Das Verfahren der oben genannten Art ist erfindungsgemäß dadurch gekennzeichnet, dass mit einem Temperaturfühler eine Temperatur zumindest des Oszillatorverstärkers bestimmt wird, dass als Oszillatorverstärker ein Verstärkerbaustein mit einem steuerbaren Netzwerk, welches ein passives Kopplungsnetzwerk und einen steuerbaren Steilheitsverstärker aufweist, verwendet wird, dass eine Übertragungsfunktion des steuerbaren Netzwerks mit dem Steilheitsverstärker gesteuert wird, wobei ein von einem Ausgangssignal des Temperaturfühlers abgeleitetes Signal als Steuersignal für den Steilheitsverstärker dient, und dass die Übertragungsfunktion des Netzwerks in Abhängigkeit zumindest von der von dem Temperaturfühler gemessenen Temperatur mittels Verstärkungsvariation am Steilheitsverstärker so gesteuert wird, dass temperaturbedingte Variationen des Oszillators wenigstens teilweise kompensiert werden.

Als Steilheitsverstärker kann bevorzugt ein steuerbarer Differenzverstärker verwendet werden.

Als Kerngedanke der vorliegenden Erfindung kann angesehen werden, bei einem Aufbau mit einem Oszillatorverstärker und einem weitestgehend eigenkompensierten Rückkopplungsnetzwerk zum Ausgleich von Bauteilestreuungen und/oder zum Ausgleich von Temperaturabhängigkeiten höherer Ordnung ein steuerbares Netzwerk im Oszillatorverstärker vorzusehen, das so gesteuert wird, dass noch verbliebene temperaturbedingte Variationen von Eigenschaften des Rückkopplungsnetzwerks, die von den individuellen Einbauverhältnissen des Spulensystems herrühren, also etwa der Schwingkreisimpedanz und/oder sonstiger Komponenten, weitestgehend kompensiert werden.

Ein erster wesentlicher Vorteil der Erfindung kann darin gesehen werden, dass der Näherungsschalter im Vergleich zu den aus dem Stand der Technik bekannten Lösungen sehr einfach aufgebaut und deshalb kostengünstig herstellbar ist.

Das erfindungsgemäße Verfahren beinhaltet nur wenige Verfahrensschritte, so dass auch auf diesem Weg Kosten eingespart werden können.

Schließlich können mit Hilfe des erfindungsgemäßen Näherungsschalters und des erfindungsgemäßen Verfahrens deutlich erhöhte Schaltabstände erzielt werden.

Auch ein kostengünstiger Chargenabgleich ist bei dem erfindungsgemäßen Näherungsschalter und mit Hilfe des erfindungsgemäßen Verfahrens prinzipiell möglich.

Bei dem erfindungsgemäßen Näherungsschalter weist der Oszillatorverstärker einen Verstärkerbaustein und ein steuerbares Netzwerk zum Steuern der Verstärkung des Oszillatorverstärkers auf.

Grundsätzlich ist es möglich, dass das durch das Target beeinflussbare Rückkoppelnetzwerk im Gegenkopplungszweig und das steuerbare Netzwerk im Mitkopplungszweig des Verstärkerbausteins vorgesehen ist. Bevorzugt ist aber eine Variante, bei der das durch das Target beeinflussbare Rückkoppelnetzwerk im Mitkopplungszweig und das steuerbare Netzwerk im Gegenkopplungszweig des Verstärkerbausteins vorgesehen ist. Das Rückkoppelnetzwerk kann dann auch als Mitkoppelnetzwerk und das steuerbare Netzwerk auch als Gegenkopplungsnetzwerk bezeichnet werden.

Ein Aufbau, bei dem das durch das Target beeinflussbare Rückkopplungsnetzwerk in den Gegenkopplungszweig des Verstärkers geschaltet wird und das steuerbare Netzwerk inklusive aktivem Shunt im Mitkopplungszweig des Verstärkers angeordnet wird, würde an der prinzipiellen Funktion nichts ändern. Lediglich die Wirkungsrichtung wäre umgekehrt. Führt also bei der hier als bevorzugt beschriebenen Variante eine Bedämpfung durch Verringerung der Transmission zu einem Zusammenbrechen der Schwingung oder zumindest einer Verkleinerung der Schwingungsamplitude, würde sich bei der wie vorstehend beschrieben modifizierten Variante gerade das umgekehrte Verhalten zeigen.

Erfindungsgemäß weist das steuerbare Netzwerk ein passives Kopplungsnetzwerk, insbesondere ein Gegenkopplungsnetzwerk, und eine steuerbare aktive Beeinflussungsvorrichtung auf. Dies ist schaltungsmäßig unaufwändig zu realisieren. Besonders bevorzugt wird das passive Gegenkopplungsnetzwerk ebenfalls temperaturstabil ausgebildet.

Als steuerbare aktive Beeinflussungsvorrichtung wird erfindungsgemäß ein steuerbarer Steilheitsverstärker verwendet, der insbesondere mit Hilfe einer Steuerspannung und/oder mittels eines Steuerstroms steuerbar ist. Hierbei kann auf bekannte Komponenten zurückgegriffen werden.

Eine zumindest linear nominale Eigenkompensation des Rückkopplungsnetzwerks kann erreicht werden, wenn das Rückkopplungsnetzwerk eine bifilare Spule mit einer ersten und einer zweiten Wicklung aufweist, wobei die erste Wicklung und die zweite Wicklung aus Mehrfach-Litzen mit unterschiedlicher Litzenzahl, d.h. unterschiedlicher Zahl der Litzendrähte, und unterschiedlichen Litzendrahtdicken gebildet sind.

Bei einer besonders bevorzugten Variante des erfindungsgemäßen Näherungsschalters ist die erste Wicklung aus einem Einzeldraht und die zweite Wicklung aus einer Mehrfachlitze gebildet. Mit einer solchen Anordnung kann eine hervorragende Eigenkompensation des Spulensystems, insbesondere der Temperaturabhängigkeit der Kupferverluste, erzielt werden.

Ein weiterer Vorteil der bifilaren Spule besteht darin, dass keine zusätzlichen Verluste in das System durch Maßnahmen zur Temperaturkompensation eingebracht werden müssen.

Um Nachteile bei der Fertigung zu vermeiden, ist in diesem Zusammenhang bei der bevorzugten Variante außerdem von Vorteil, wenn der Einzeldraht oder die Litzendrähte der ersten Wicklung einen größeren Querschnitt aufweisen als die Litzendrähte der Mehrfachlitze der zweiten Wicklung. Hierdurch kann die Handhabbarkeit, insbesondere die Lötbarkeit, des Einzeldrahts verbessert werden.

Grundsätzlich ist man bei einer Spule immer bestrebt, die Einzeldrähte der Litze möglichst dünn zu wählen, um die so genannten Proximity-Verluste, die auf Wirbelstromverluste in angrenzenden Drähten zurückgehen, möglichst gering zu halten. Aus Gründen der Handhabbarkeit können aber die Einzeldrähte nicht beliebig dünn gewählt werden, da sie sonst beispielsweise beim Löten verbrennen würden.

Eine gute Handhabbarkeit des Einzeldrahts der ersten Wicklung bei der bevorzugten Variante bei noch tolerierbaren Proximity-Verlusten kann erzielt werden, wenn die Dicke des Einzeldrahts der ersten Wicklung zwischen 60 und 100 µm, bevorzugt etwa 70 µm, beträgt.

Bei der Mehrfachlitze der zweiten Wicklung sind im Hinblick auf die Verarbeitbarkeit auch kleinere Durchmesser möglich aber nicht zwingend. Eine noch hinreichend zuverlässig verarbeitbare Mehrfachlitze bei tolerierbaren Proximity-Verlusten wird erzielt, wenn die Dicke der Einzeldrähte der Mehrfachlitze der zweiten Wicklung zwischen 20 und 50 µm, bevorzugt etwa 30 µm, beträgt.

Grundsätzlich ist es auch denkbar, dass bei Annäherung des Targets eine Variation der Transmission des Mitkopplungsnetzwerks durch eine Änderung der Schwingkreiskapazität herbeigeführt wird, es sich also um einen kapazitiven Näherungsschalter handelt. Bevorzugt ist der Näherungsschalter jedoch als induktiver Näherungsschalter ausgebildet.

Zum Aufbau des weitestgehend eigenkompensierten Oszillatorverstärkers wird bevorzugt ein Verstärkerbaustein mit möglichst hoher Leerlaufverstärkung kombiniert mit einer starken Gegenkopplung, bestehend aus einem passiven Gegenkopplungszweig und einem parallelen steuerbaren aktiven Gegenkopplungszweig verwendet. Der Oszillatorverstärker kann dann aufgrund der starken Gegenkopplung als nahezu idealer Verstärker angesehen werden, dessen Eingangsimpedanz und Transmission und damit dessen Schleifen- und Spannungsverstärkung weitgehend unabhängig von Aussteuerung und Temperatur ist. Bevorzugt weist der Oszillatorverstärker weiterhin eine durch eine Steuerspannung oder einen Steuerstrom veränderbare Verstärkungskennlinie auf, welche durch die Steuergröße im Wesentlichen parallel verschiebbar ist. Bevorzugt ist hierbei außerdem ein praktisch linearer Zusammenhang zwischen Verschiebung und Steuergröße gegeben, so dass sich die Steuerung der Verstärkung schaltungstechnisch besonders einfach bewerkstelligen lässt. Schließlich ist es von Vorteil, wenn der Zusammenhang zwischen Verschiebung der Verstärkungskennlinie und der Steuergröße weitestgehend temperaturunabhängig ist, d.h. wenn die Änderung der Verstärkung praktisch unabhängig von Aussteuerung und Temperatur ist.

Der Oszillatorverstärker kann insbesondere ein stark gegengekoppelter Verstärker mit definiertem Zusammenhang zwischen Verstärkung und Aussteuerung sein. Alternativ kann auch ein definierter Zusammenhang zwischen Spannungsverstärkung oder Verstärkungsänderung und Aussteuerung vorliegen.

Vorteilhaft ist weiterhin, wenn der gegengekoppelte Verstärker eine definierte Kennlinie bezüglich Temperatur und Verstärkung, insbesondere eine lineare bzw. konstante Kennlinie im nichtbeeinflussten Betrieb aufweist. Hierunter soll eine Situation verstanden werden, bei welcher keine Beeinflussung durch die Regelspannung vorliegt, d.h. dass im Gegen- bzw. Mitkopplungszweig die Nominalimpedanzen vorliegen.

Zweckmäßig kann schließlich ein Oszillator mit einer definierten Impedanz-Kennlinie über Temperatur und Frequenz verwendet werden.

Eine Änderung der Verstärkung des Oszillatorverstärkers kann grundsätzlich durch eine aktive oder passive Beeinflussung der Impedanz im Gegenkopplungszweig des Oszillatorverstärkers erfolgen. Beispielsweise kann eine Beeinflussung der Gegenkoppelimpedanz durch HF-taugliche schaltbare Impedanz-Arrays oder Impedanzketten bewerkstelligt werden.

Erfindungsgemäß erfolgt die Beeinflussung der Impedanz steuerbar durch eine Steuergröße mit einem Steilheitsverstärker (transconductance amplifier). Diese Ausführung kann auch als aktiver Shunt bezeichnet werden.

Grundsätzlich kann die Spannung in den Schwingkreis über eine beliebige Impedanz, beispielsweise also auch einen ohmschen Widerstand eingekoppelt werden. Besonders elegant, da dann keine weiteren Bauteile zur Bereitstellung der richtigen Phasenlage notwendig sind, ist es aber, wenn zur Einkopplung der Spannung in den Schwingkreis eine Koppelkapazität vorgesehen ist. Zur Impedanzanpassung kann zweckmäßig ein ohmscher Widerstand in Reihe zur Koppelkapazität geschaltet werden.

Bei einer weiteren bevorzugten Ausführungsform sind dem Oszillatorverstärker ein Gleichrichter und ein Komparator mit fester Schaltschwelle nachgeschaltet. Der Einsatz eines Komparators mit fester Schaltschwelle ist insbesondere dann möglich und nutzbringend, wenn der eingesetzte Verstärker über einen besonders großen Bereich der Aussteuerung eine konstante Verstärkung aufweist. Der Übergang der nahe bei 0 liegenden minimalen Amplitude und der maximalen Amplitude erfolgt dann über eine besonders kleine Wegstrecke des das Spulensystem beeinflussenden Targets, so dass im Hinblick auf die konkrete Schaltschwelle keine hohe Genauigkeitsanforderung gestellt ist. Hierdurch können der schaltungstechnische Aufwand gesenkt und Kosten gespart werden.

Ein weiterer Vorteil eines aktiven Shunts besteht außerdem darin, dass die Verstärkung des Oszillatorverstärkers geändert wird, im Wesentlichen ohne in die Linearitätseigenschaften dieses Verstärkers einzugreifen.

Als Temperaturfühler können grundsätzlich alle bekannten Varianten, insbesondere auch Thermoelemente oder speziell hierfür vorgesehene Halbleiterbauelemente, eingesetzt werden. Zweckmäßig wird bei einer bevorzugten Variante des erfindungsgemäßen Näherungsschalters aber ein NTC-Netzwerk als Temperaturfühler eingesetzt. NTC-Netzwerke weisen bei vertretbaren Kosten eine ausreichende Linearität auf.

Um ein rasches Anschwingen des Oszillators zu ermöglichen, hat sich darüber hinaus als zweckmäßig erwiesen, wenn die Verstärkung des Oszillatorverstärkers aussteuerungsabhängig verändert wird. Konkret wird dabei die Verstärkung gezielt bei kleinen Aussteuerungen bzw. Schwingamplituden angehoben. Schaltungsmäßig kann dies beispielsweise dadurch realisiert werden, dass ein Ausgang des Gleichrichters mit dem steuerbaren Oszillatorverstärker, insbesondere mit dem Verstärkerbaustein, verbunden wird, so dass die Verstärkung aussteuerungsabhängig, nämlich in Abhängigkeit der von dem Gleichrichter gelieferten Spannung, verändert wird.

Besonders bevorzugt ist eine Variante des erfindungsgemäßen Verfahrens, bei welcher die Verstärkung des Oszillatorverstärkers über Temperatur stückweise linear nachgeführt wird. Hierunter wird eine Verfahrensweise verstanden, bei welcher bei einer Mehrzahl von Punkten ein Abgleich der Verstärkung vorgenommen und anschließend zwischen diesen Punkten eine lineare Interpolation der Verstärkungskennlinie durchgeführt wird. Bei einer besonders einfachen, gleichwohl sehr effektiven Variante wird bei beispielsweise drei Temperaturen ein Abgleich der Verstärkung vorgenommen und zwischen diesen drei Punkten erfolgt anschließend eine lineare Interpolation. Die Verstärkungskennlinie besteht in diesem Fall aus zwei linearen Teilbereichen. Diese ökonomische Verfahrensweise, die auch als Drei-Punkt-Abgleich bezeichnet wird, hat sich für zahlreiche Anwendungen als völlig ausreichend erwiesen.

Auch eine nichtlineare Interpolation, z.B. mittels Bezier-Kurve, ist möglich und sinnvoll.

Ein weiterer Vorteil einer stückweise linearen Verstärkungskennlinie ist außerdem darin zu sehen, dass die Berechnung der einzelnen Kennlinienpunkte besonders einfach erfolgen kann.

Auch eine chargenbezogene Einprägung der Verstärkungskennlinie ist nach stichprobenmäßiger Bestimmung der Bauteileigenschaften möglich.

Der erfindungsgemäße Näherungsschalter und das erfindungsgemäße Verfahren gestatten außerdem für eine bestimmte Baugröße des Näherungsschalters eine Dimensionierung und/oder eine Optimierung der verwendeten Komponenten einmalig mit Hilfe einer Simulation durchzuführen.

Weitere Vorteile und Merkmale des erfindungsgemäßen Näherungsschalters und des erfindungsgemäßen Verfahrens werden nachstehend unter Bezugnahme auf die beigefügten schematischen Figuren erläutert. Hierin zeigt:
Fig. 1 schematisch einen konventionellen Näherungsschalter mit Kompensationsnetzwerk;
Fig. 2 eine Darstellung, anhand derer Temperatureffekte auf den Schaltabstand erläutert werden;
Fig. 3 eine schematische Ansicht eines für ein bevorzugtes Ausführungsbeispiel der Erfindung verwendeten Spulennetzwerks;
Fig. 4 eine schematische Darstellung des Verlaufs von Verstärkungskurven eines für den erfindungsgemäßen Näherungsschalter einzusetzenden Verstärkers;
Fig. 5 eine schematische Darstellung eines für den erfindungsgemäßen Näherungsschalter einzusetzenden Verstärkers;
Fig. 6 eine schematische Darstellung eines Ausführungsbeispiels des erfindungsgemäßen Näherungsschalters;
Fig. 7 eine schematische Darstellung des Verlaufs des Schaltabstands in Abhängigkeit der Temperatur vor gezielter Veränderung der Verstärkung;
Fig. 8 eine schematische Darstellung einer Verstärkungskennlinie, die aus dem Verlauf nach Fig. 7 gewonnen wurde;
Fig. 9 eine schematische Darstellung des Abgleich-Verfahrens;
Fig. 10 eine schematische Darstellung der Nachführung der Verstärkung; und
Fig. 11 den Verlauf des Schaltabstands für einen konkreten Prototypen.

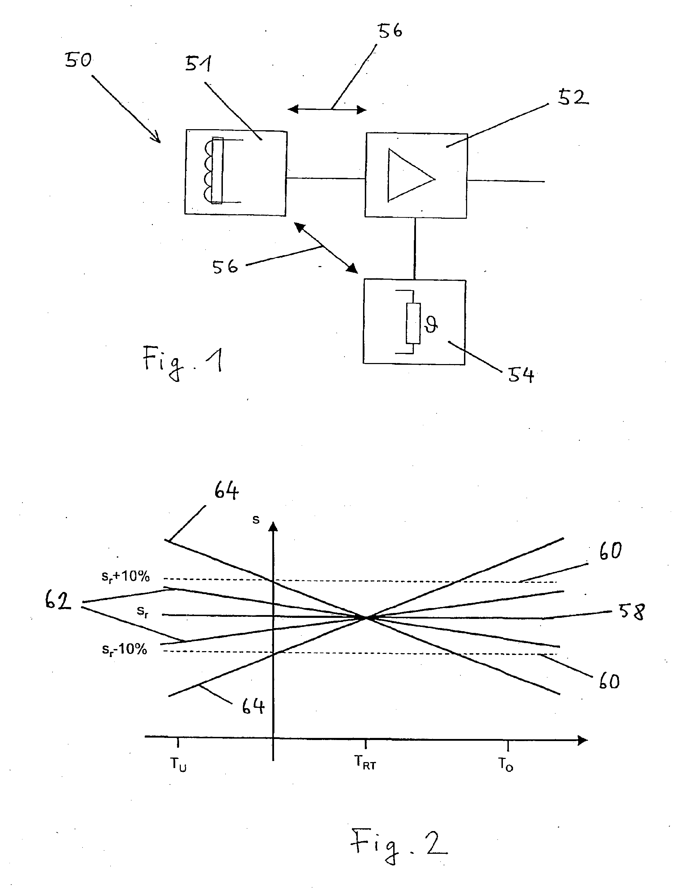

Zunächst wird die grundlegende Problemstellung anhand der schematischen Skizze eines konventionellen Systems 50 in Fig. 1 erläutert. Dieses System 50 besteht im Wesentlichen aus einem Spulensystem 51, einem Verstärker 52 und einem Kompensationsnetzwerk 54 zur Kompensation von Temperaturabhängigkeiten des Spulensystems und des Verstärkers. Eine räumliche Trennung dieser Teilkomponenten ist durch Pfeile 56 angedeutet. Aus prinzipiellen Gründen ist nun der mit einem Näherungsschalter erzielbare maximale Schaltabstand begrenzt. Zunächst bestehen aufgrund der räumlichen Trennung immer gewisse Temperaturdifferenzen zwischen den einzelnen Komponenten, beispielsweise zwischen Spulensystem und Verstärker/Kompensationsnetzwerk. Diese nicht vollständig eliminierbaren Temperaturdifferenzen führen zu Nachführfehlern bei Temperaturänderungen.

Weiterhin kann eine Anpassung oder ein "matching" zwischen dem Kompensationsnetzwerk, dem Verstärker und dem Spulensystem nur mit begrenzter Präzision durchgeführt werden.

Schließlich weisen die verwendeten Bauelemente, insbesondere des Spulensystems aber auch des Verstärkers, Parameterstreuungen und Fertigungstoleranzen auf, die die Reproduzierbarkeit der Teilkomponenten begrenzen.

Der Einfluss dieser Parameterstreuungen ist schematisch in Fig. 2 dargestellt. Aufgetragen ist dort der Schaltabstand s gegenüber der Temperatur. Ein nominaler Schaltabstand sᵣ ist dabei durch eine horizontale Gerade 58 dargestellt. Durch gestrichelte horizontale Geraden 60 ist darüber hinaus ein Bereich einer 10%-Abweichung von diesem nominalen Schaltabstand sᵣ gekennzeichnet. Der Einfluss von Störgrößen auf den tatsächlichen Schaltabstand hängt näherungsweise exponentiell vom nominalen Schaltabstand ab.

Wenn man nun zu höheren Schaltabständen übergeht, beobachtet man aus diesem Grund rasch anwachsende Abweichungen vom nominalen Schaltabstand mit zunehmendem Abstand von der Raumtemperatur. Dies ist in Fig. 2 schematisch durch die Geraden 64 dargestellt, die bereits deutlich oberhalb der unteren Betriebstemperatur Tᵤ und bereits deutlich unterhalb der oberen Betriebstemperatur Tₒ die als tolerierbar erachtete 10%-Umgebung verlassen. Ein Verlauf, der noch akzeptabel wäre und somit anzustreben ist, ist durch die Geraden 62 dargestellt.

Um deutlich erhöhte Schaltabstände zu erzielen, wird deshalb erfindungsgemäß als erster Schritt vorgeschlagen, ein linear nominal eigenkompensiertes Mitkopplungsnetzwerk und einen weitestgehend eigenkompensierten Oszillatorverstärker zu verwenden. Die Eigenkompensation soll dabei möglichst wenig durch typische Parameterstreuungen bzw. Fertigungstoleranzen beeinflussbar sein und außerdem sollen Temperatureinflüsse höherer Ordnung minimiert werden.

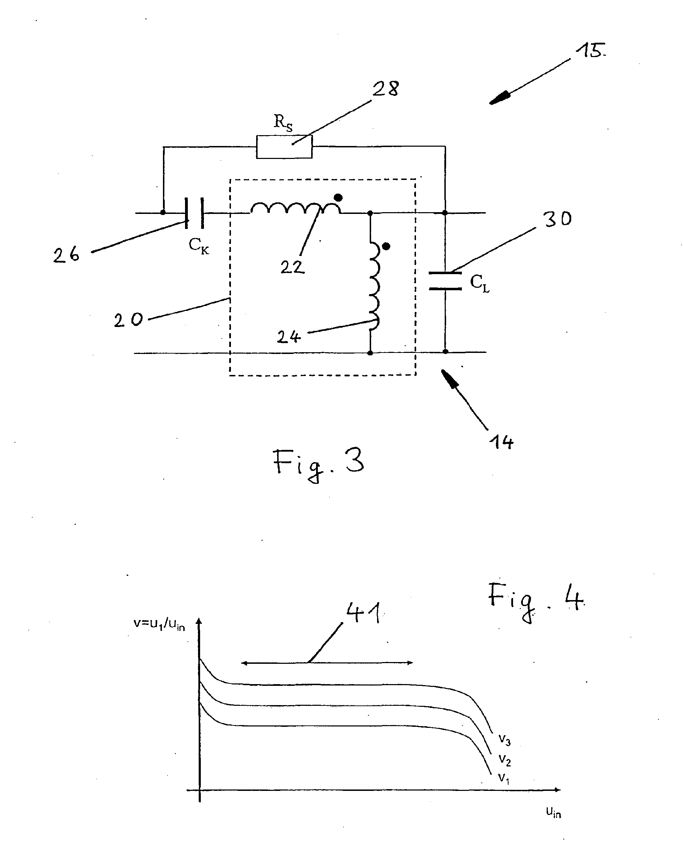

Ein Beispiel eines erfindungsgemäßen eigenkompensierten Oszillators, bestehend aus Oszillatorverstärker und Mitkopplungsnetzwerk, wird mit Bezug auf die Fig. 3 bis 5 erläutert.

In Fig. 3 ist schematisch ein bezüglich der Temperatur eigenkompensiertes Netzwerk dargestellt. Es handelt sich dabei im Wesentlichen um ein Bifilar-Spulensystem mit einer externen Beschaltung, dessen Transmission bei entsprechender Auslegung zumindest in erster Näherung temperaturunabhängig gemacht werden kann, und dann lediglich von der Bedämpfung der Spule 20 z.B. durch ein zu detektierendes Target abhängt. Kernbestandteil dieses Spulensystems ist eine bifilare Spule 20, die aus einer ersten Wicklung 22 und einer zweiten Wicklung 24 aufgebaut ist. Die erste und die zweite Teilwicklung sind antiseriell und innig verbunden angeordnet, so dass eine praktisch vollständige induktive Kopplung zwischen diesen Teilwicklungen vorliegt. Im Hinblick auf die Herstellung dieses Spulensystems ist es von Vorteil, wenn die Teilwicklungen einen unterschiedlichen Aufbau haben. Insbesondere wird die erste Teilwicklung 22 bevorzugt aus einem Einzeldraht und die zweite Teilwicklung 24 bevorzugt aus einer Mehrfach-Litze gebildet. Dabei ist außerdem der Einzeldraht der ersten Wicklung zweckmäßig dicker gewählt als die Einzeldrähte der Mehrfach-Litze. Auf diese Weise können Lötprobleme vermieden und die Proximity-Verluste in einem akzeptablen Rahmen gehalten werden. Als weitere Komponente des eigentlichen Schwingkreises 14 ist eine Kapazität 30 parallel zur zweiten Wicklung 24 der bifilaren Spule 20 geschaltet. Eine Eingangsspannung wird über eine Koppelkapazität 26 über die erste Wicklung 22 auf den Schwingkreis 14 gegeben. Durch die Koppelkapazität 26 wird außerdem die richtige Phasenlage der anregenden Spannung bereitgestellt.

Durch entsprechende Gewichtung der Koppelkapazität 26 und eines Shunt-Widerstands 28 ist eine Temperaturkompensation realisierbar. Die Optimierung der externen Beschaltung wird dabei mit einer Soll-Transmission als Randbedingung durchgeführt. Voraussetzung hierfür ist, dass das Spulensystem unterhalb der Eigenkompensationsfrequenz betrieben wird.

Mit diesem eigenkompensierten Mitkopplungsnetzwerk können gegenüber einer konventionellen Realisierung zahlreiche Vorteile erzielt werden. Zum einen erfolgt eine inhärente Temperaturkompensation durch eine Parametrierung der externen Beschaltung. Außerdem können parasitäre Verluste, wie beispielsweise "Proximity-Verluste", minimiert werden, da die beiden Spulenwicklungen prinzipiell völlig unabhängig von den der Kompensation dienenden Komponenten gewählt werden können. Weiterhin weist dieser Aufbau nur sehr kleine Temperaturkoeffizienten höherer Ordnung auf. Ein Vorteil dieses Netzwerks besteht schließlich auch darin, dass der resultierende Temperaturkoeffizient eine sehr geringe Frequenzabhängigkeit hat. Insgesamt liegt bei diesem Netzwerk, welches in dem Oszillator als Mitkopplungsnetzwerk fungiert, wie oben beschrieben, eine inhärente Eigenkompensation der Transmission vor.

Die weitere wesentliche Komponente des Oszillators ist der Oszillatorverstärker. Um induktive Sensoren mit deutlich erhöhten Schaltabständen, bei denen der Target-Effekt im Bereich nur einiger tausend ppm liegt, realisieren zu können, sollten die verwendeten Oszillatorverstärker im Wesentlichen drei Anforderungen genügen.

Zunächst ist eine hohe Stabilität der Spannungs-Verstärkung über die Temperatur erwünscht. Die maximale relative Verstärkungsvariation sollte möglichst weit unterhalb des Target-Effekts liegen.

Weiterhin sollte eine möglichst hohe Linearität gegeben sein, d.h. die Grundwellenverstärkung sollte über einen großen Aussteuerungsbereich unabhängig von der jeweiligen Verstärkung möglichst konstant sein. Kleine Transmissionsänderungen im Mitkopplungszweig, die sich durch die Bedämpfung der Spule durch das Target ergeben, werden dann auf einen möglichst großen Amplitudenhub abgebildet. Auf diese Weise wird der Störabstand maximiert. Dies bezieht sich insbesondere auf den Störabstand im Hinblick auf Störeinflüsse des Gleichrichters und des Komparators, also den Störabstand bezüglich der Signalauswertung.

Schließlich sollte der Verstärker eine möglichst hohe und über die Temperatur möglichst konstante Eingangsimpedanz, möglichst größer als 1 Megaohm, aufweisen.

Diese Forderungen können mit einem stark gegengekoppelten Verstärker erreicht werden. Grundlage ist dabei ein Verstärkerbaustein mit einer hohen Leerlaufverstärkung, der gedanklich zunächst über ein passives Netzwerk gegengekoppelt wird. Bei genügend großer Leerlaufverstärkung wird das Verhalten dieses Systems nahezu ausschließlich vom passiven Gegenkopplungsnetzwerk bestimmt, d.h. Halbleiterparameter und deren Temperaturabhängigkeiten treten in den Hintergrund.

Ausgehend von einem massiv gegengekoppelten Verstärker mit einem fest vorgegebenen passiven Gegenkopplungsnetzwerk, der als Kernoszillator bezeichnet werden kann, erfolgt die Steuerung der Verstärkung durch eine parallele Erweiterung des Gegenkopplungsnetzwerks mit einem "aktiven Shunt" in Form eines linearisierten und temperaturkompensierten Differenzverstärkers. Durch direkte oder spannungsgesteuerte Variation des Differenzverstärkerstroms wird proportional dessen Übertragungssteilheit und damit der Einfluss auf das Gegenkopplungsnetzwerk des Kernoszillators verändert. Dies bewirkt wiederum eine Änderung der Verstärkung des Gesamtsystems. Das Prinzip arbeitet unabhängig von der konkreten Realisierung des Kernoszillators, sofern es sich um einen gegengekoppelten Verstärker handelt. Auf diese Weise wird ein Oszillatorverstärker realisiert, der den oben genannten Anforderungen genügt und gleichzeitig die Möglichkeit einer Verstärkungsvariation mit Hilfe einer Steuergröße bietet. Dadurch kann prinzipiell ein softwarebasierender Abgleich des Näherungsschalters zur Eliminierung der Einflüsse mangelnder Reproduzierbarkeit von Spulen- und Bauteilparametern erzielt werden. Verstärkungsstabilität, Linearität und Eingangsimpedanz sind dabei weitgehend unabhängig von der jeweils vorliegenden Verstärkung.

Fig. 4 zeigt schematisch drei verschiedene Verläufe der Verstärkung bei vorgegebenem Gegenkopplungsnetzwerk, erzeugt durch drei verschiedene Werte der Steuergröße, hier der Steuerspannung, für die Steilheit des Differenzverstärkers. Die Verläufe weisen jeweils, wie durch den Doppelpfeil 41 dargestellt, einen ausgedehnten Linearitätsbereich auf, der sich über einen großen Aussteuerungsbereich erstreckt. Durch diesen ausgedehnten Linearitätsbereich wird gewährleistet, dass kleine Transmissionsänderungen im Mitkopplungszweig auf einen großen Amplitudenhub abgebildet werden und auf diese Weise der Störabstand minimiert wird. Außerdem kann hierdurch erreicht werden, dass im Hinblick auf die Komparatorschwelle keine sehr strengen Genauigkeitsanforderungen zu stellen sind. Wie aus Fig. 4 außerdem ersichtlich, steigt die Verstärkung bei geringen Aussteuerungen für die drei dargestellten Verläufe jeweils an. Dies ist ein erwünschtes und vorteilhaftes Verhalten, da auf diese Weise ein Zusammenbrechen der Amplitude bei geringen Targetabständen verhindert und ein An- bzw. Aufschwingen des Oszillators erleichtert wird. Bei hohen Aussteuerungen sinkt die Verstärkung jeweils ab, wodurch die Amplitude des Oszillators begrenzt wird.

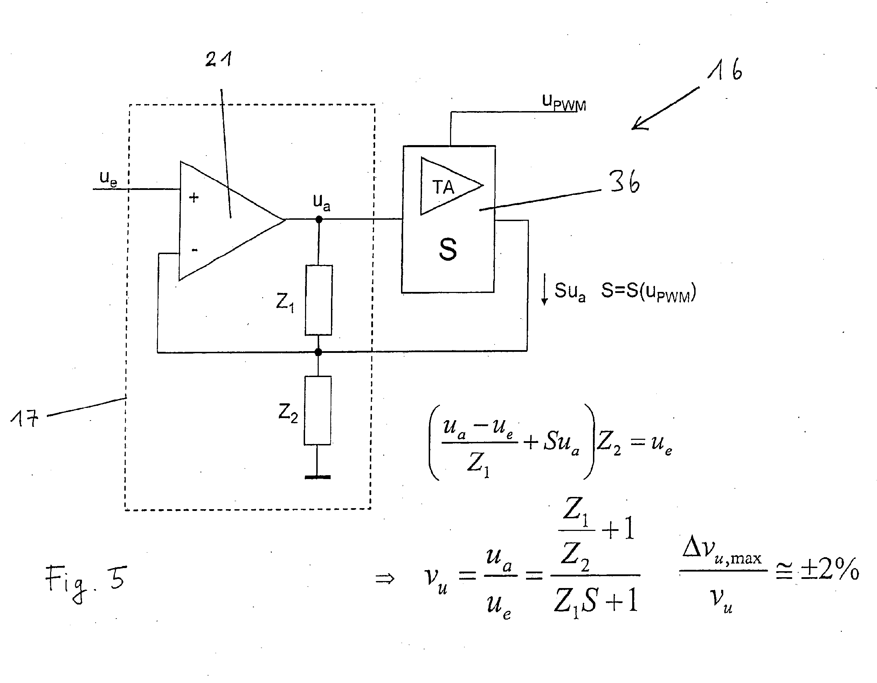

In Fig. 5 ist schematisch ein Ausführungsbeispiel eines bei dem erfindungsgemäßen Näherungsschalter einzusetzenden Oszillatorverstärkers 16 gezeigt.

Wesentlicher Bestandteil dieses Oszillatorverstärkers 16 ist ein Kernoszillator 17, bestehend aus einem Verstärkerbaustein 21 und einem fest vorgegebenen passiven Gegenkopplungsnetzwerk aus den Impedanzen Z₁ und Z₂. Eingebaut in das Gegenkopplungsnetzwerk ist darüber hinaus ein Steilheitsverstärker 36, der mit Hilfe einer Spannung U_{PWM} angesteuert wird. Durch den Steilheitsverstärker 36 wird ein Strom Suₐ in das Gegenkopplungsnetzwerk eingeprägt, wobei die Steilheit S eine Funktion der Steuerspannung U_{PWM} ist. Durch diese Anordnung ergibt sich die in Fig. 5 dargestellte Abhängigkeit der Verstärkung vᵤ von der Steilheit S des Steilheitsverstärkers 36.

Der Verstärker kann beispielsweise so konfiguriert werden, dass die Verstärkungsvariation über die Steuerspannung ca. +/-2% beträgt. Die Rest-Temperatureinflüsse sind im Idealfall deutlich kleiner als das Nutzsignal, d.h. kleiner als typischerweise 0,3%.

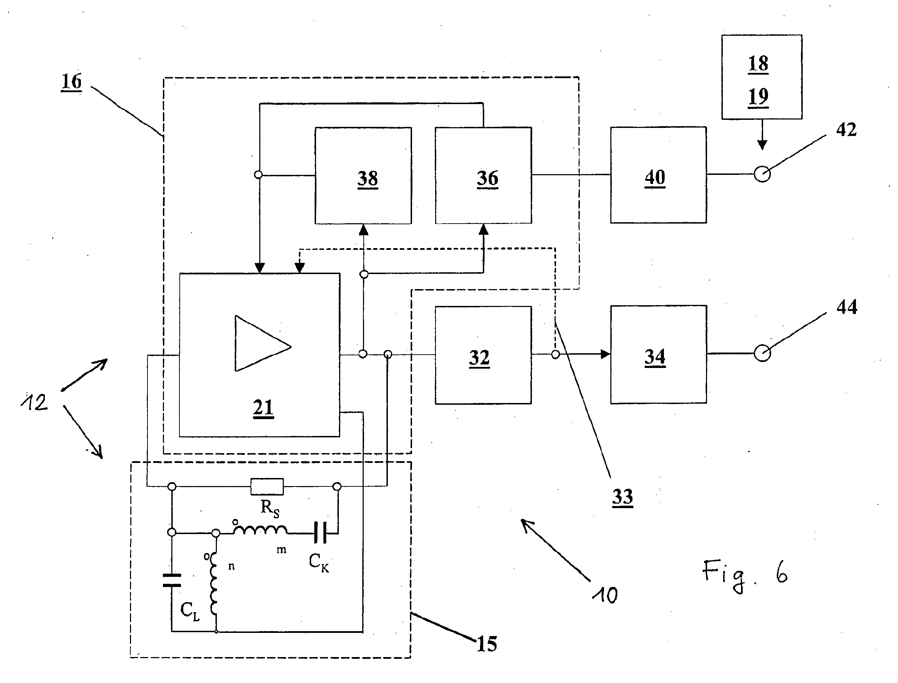

In Fig. 6 ist ein Ausführungsbeispiel eines erfindungsgemäßen Näherungsschalters 10 in einer schematischen Teildarstellung gezeigt. Kernbestandteil dieses induktiven Näherungsschalters 10 ist der zuvor beschriebene linear eigenkompensierte Oszillator 12 mit Mitkopplungsnetzwerk 15 und Oszillatorverstärker 16. Der Oszillatorverstärker 16 besteht, wie oben im Zusammenhang mit Fig. 5 beschrieben, aus dem eigentlichen Verstärkerbaustein 21, einem vorgegebenen passiven Gegenkopplungsnetzwerk 38 sowie dem Steilheitsverstärker 36, mit dem die Verstärkung des Verstärkers 16 insgesamt eingestellt werden kann. Der Verstärkerbaustein 21 ist über das Mitkopplungsnetzwerk 15 mitgekoppelt. Dem Steilheitsverstärker 36 wird direkt oder aus einem Spannungs-/Strom-Konverter 40 ein Steuersignal zugeführt. Dieses Steuersignal leitet sich ab von einem Ausgangssignal eines erfindungsgemäß vorgesehenen Temperaturfühlers 18, der direkt oder über Zwischenkomponenten mit einem Eingang 42 des Konverters 40 verbunden ist oder direkt mit dem Steilheitsverstärker verbunden ist. Bei dem Temperaturfühler 18 handelt es sich im dargestellten Fall um ein NTC-Netzwerk 19.

Das Ausgangssignal des Verstärkerbausteins 21 wird mit Hilfe eines Gleichrichters 32 gleichgerichtet und anschließend einem Komparator 34 zugeführt, der den gleichgerichteten Spannungswert mit einer festen Komparatorschwelle vergleicht und als Ergebnis dieses Vergleichs ein Ausgangssignal 44 abgibt. Der Ausgang des Gleichrichters 32 ist im gezeigten Beispiel außerdem über eine schematisch gezeigte Leitung 33 zu dem Verstärkerbaustein 21 zurückgeführt. Die Schaltung ist im Einzelnen so aufgebaut, dass bei niedriger Aussteuerung des Verstärkerbausteins 21 bzw. kleiner Schwingungsamplitude gezielt eine Erhöhung der Verstärkung herbeigeführt wird, um das Zusammenbrechen der Schwingungsamplitude zu verhindern und um das Aufschwingen des Oszillators 12 zu erleichtern.

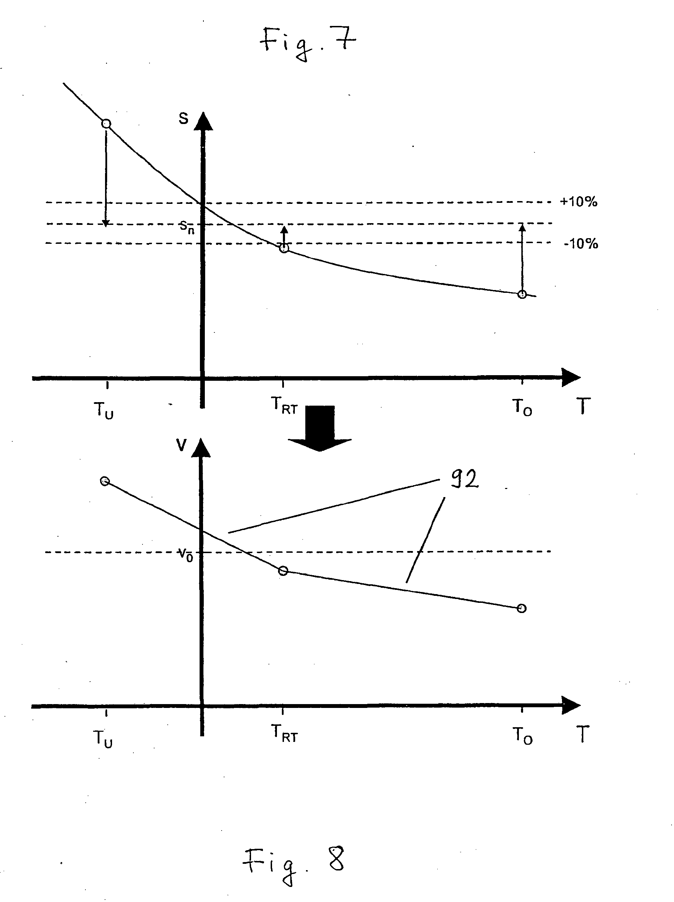

Das erfindungsgemäße Verfahren, insbesondere die Gewinnung des Zusammenhangs zwischen Verstärkung und Temperatur wird nachstehend mit Bezug auf die Fig. 7 bis 10 erläutert.

In Fig. 7 ist ein typischer Verlauf des Schaltabstands in Abhängigkeit der Temperatur dargestellt. Wie ersichtlich, ergeben sich im Bereich einer unteren Betriebstemperatur T_{U} und einer oberen Betriebstemperatur Tₒ bereits erhebliche, den 10%-Rahmen deutlich übersteigende Abweichungen von einem Soll-Schaltabstand Sₙ. Bei der tiefen Betriebstemperatur Tᵤ beobachtet man einen deutlich zu großen Schaltabstand. Das bedeutet, dass die Bedämpfung des Oszillators durch das Target bereits bei einem Abstand, der erheblich größer ist als der Soll-Schaltabstand, ausreicht, um die Schwingung des Oszillators zum Erliegen zu bringen bzw. unter die Komparatorschaltschwelle abzusenken. Folglich muss für diese Temperatur eine höhere Verstärkung gewählt werden. Andererseits ist bei der oberen Betriebstemperatur Tₒ der beobachtete Schaltabstand zu gering, d.h., dass das Target deutlich näher als bis zum Schaltabstand an den Näherungsschalter herangeführt werden muss, um eine hinreichende Dämpfung des Oszillators zu bewirken. Das bedeutet, dass für diese Temperatur Tₒ die Verstärkung zu groß war, demgemäß also abgesenkt werden muss. In ähnlicher Weise muss die Verstärkung auch bei Raumtemperatur T_{RT} geringfügig abgesenkt werden. Auf diese Weise erhält man die drei in Fig. 8 dargestellten Abgleichpunkte für die Verstärkung. Eine Verstärkungskurve über den gesamten Bereich der Betriebstemperaturen von Tᵤ bis Tₒ kann, wie durch die Pfeile 92 angedeutet, in einfacher Weise durch lineare Interpolation zwischen den bei den drei genannten Temperaturen ermittelten Werten erreicht werden.

Bei dem erfindungsgemäßen Verfahren werden also an wenigen, vorzugsweise drei Stützpunkten im gewünschten Temperaturbereich die Werte für die Regelspannung ermittelt und die entsprechenden Korrekturwerte werden in einem nichtflüchtigen Speicher abgelegt. Auf Grundlage des Messsignals des Temperaturfühlers 18 können dann die konkreten Steuerwerte der Regelspannung bzw. des Regelstroms z.B. mit Hilfe eines Mikroprozessors oder Mikrocontrollers jeweils punktweise errechnet werden. Die Regelspannung wird dann generiert durch einen Digital-Analog-Wandler oder durch Tiefpass-Filterung einer PWM-Quelle unter Verwendung dieser Steuerwerte. Die Nachführung der Regelspannung erfolgt dann im Temperaturbereich als Interpolation unter Verwendung der gefundenen Korrekturwerte oder wahlweise auch mit einer parametrierbaren Funktion höherer Ordnung, beispielsweise mit Hilfe der Beziers-Näherung. Eine Kommunikation mit dem Mikroprozessor oder Mikrocontroller kann beispielsweise über die Versorgungsleitungen erfolgen, wobei eine bidirektionale Übertragung der Korrektur- oder Steuerwerte und anderer Informationen und Befehle durchgeführt werden kann.

Alternativ kann prinzipiell auch die gesamte Verstärkungskurve in einem Speicher abgelegt werden. Eine punktweise Berechnung der Steuerwerte kann dann entfallen.

Alternativ ist auch eine Steuerung des Steilheitsverstärkers über einen Steuerstrom möglich.

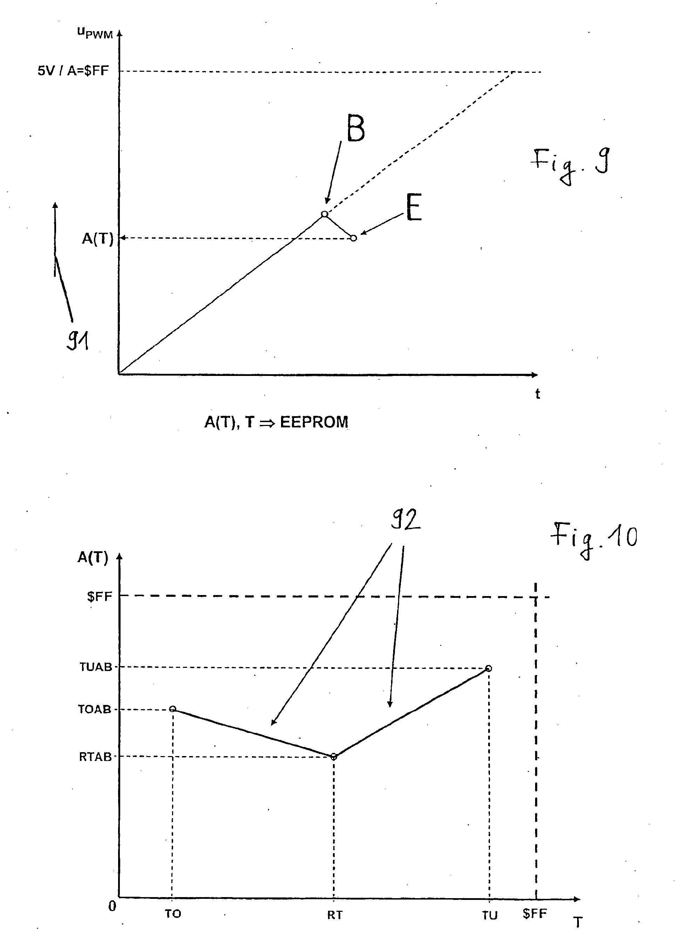

In Fig. 9 ist die Bestimmung der Korrekturwerte schematisch dargestellt. Hierbei wird das Target im Schaltabstand positioniert und die Verstärkung wird, ausgehend von einem Wert, bei dem der Oszillator jedenfalls schwingt, nach und nach abgesenkt. Auf der Y-Achse ist in Fig. 9 die Spannung U_{PWM} aufgetragen, die mit sinkender Verstärkung anwächst. In Richtung des Pfeils 91 nimmt also die Verstärkung ab. Man bewegt sich auf diese Weise bis zu einem Punkt B, bei dem der Zustand "bedämpft" erreicht ist. Anschließend wird die Verstärkung wieder so weit erhöht, bis der Oszillator gerade wieder schwingt, also ein Zustand "entdämpft" im Punkt E erreicht ist. Dieser Korrekturwert A(T) wird zusammen mit der entsprechenden Temperatur (T) in einem EEPROM abgelegt.

Aus den bei insgesamt drei Temperaturen ermittelten Korrekturwerten wird dann, wie in Fig. 10 durch die Pfeile 92 angedeutet, durch lineare Interpolation der Verlauf für den gesamten Betriebstemperaturbereich ermittelt. An der X-Achse in Fig. 10 ist ein Temperaturparameter T aufgetragen, der mit steigender Temperatur abfällt. Deshalb erscheint dort TU oberhalb der "Raumtemperatur" RT.

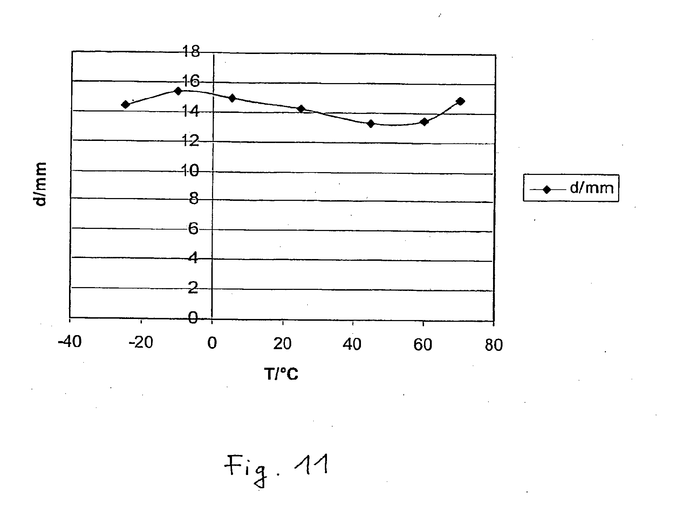

Fig. 11 schließlich zeigt einen für einen konkreten Prototypen ermittelten Verlauf des Schaltabstands im Bereich einer Betriebstemperatur von -25 bis +70° C. Wie ersichtlich, kann bei einem Schaltabstand von etwa 15 mm die maximale Abweichung unter 10 % gehalten werden.

Durch die vorliegende Erfindung wird ein neuartiger Näherungsschalter und ein neuartiges Verfahren zum Betrieb eines Näherungsschalters bereitgestellt, durch die erhebliche Verbesserungen im Bereich des Schaltabstands und der Temperaturstabilität erzielt werden können. Die Erfindung beinhaltet im Wesentlichen eine Kombination aus einem eigenkompensierten Oszillator mit einem einstellbaren Oszillatorverstärker. Insbesondere kann ein Komparator mit fester Schwelle eingesetzt werden. Als Oszillatorverstärker wird bevorzugt ein driftarmer Verstärker mit einstellbarer Steilheit oder Verstärkung im Gegenkopplungszweig eingesetzt. Hieraus ergibt sich ein einstufiges Verfahren, welches die Aufnahme einer nur kleinen Anzahl von Stützpunkten erfordert. Auf diese Weise können statische Toleranzen, temperaturbedingte Toleranzen und temperaturbedingte Parameteränderungen in einem einstufigen Verfahren kompensiert werden.

Die Temperaturabhängigkeiten höherer Ordnung können darüber hinaus reduziert werden, wenn weitgehend temperaturstabile Komponenten, insbesondere für den eigenkompensierten Oszillator und den driftarmen Verstärker, eingesetzt werden.

## Patentansprüche

1. Näherungsschalter, insbesondere induktiver Näherungsschalter,
mit einem Oszillator (12), der ein durch ein zu detektierendes Target beeinflussbares, wenigstens teilweise eigenkompensiertes Rückkopplungsnetzwerk (15) und einen Oszillatorverstärker (16) aufweist,
wobei der Oszillatorverstärker (16) einen Verstärkerbaustein (21) und ein steuerbares Netzwerk zum Steuern der Verstärkung des Oszillatorverstärkers (16) aufweist, und
wobei das steuerbare Netzwerk ein passives Kopplungsnetzwerk, insbesondere Gegenkoppelnetzwerk (38), aufweist,
**dadurch gekennzeichnet,**
**dass** ein steuerbarer Steilheitsverstärker (36) zum Steuern einer Übertragungsfunktion des steuerbaren Netzwerks vorhanden ist,
**dass** ein Temperaturfühler (18) zur Bestimmung der Temperatur des Oszillatorverstärkers (16) vorgesehen ist, wobei ein von einem Ausgangssignal des Temperaturfühlers (18) abgeleitetes Signal als Steuersignal für den Steilheitsverstärker (36) dient, und
**dass** das steuerbare Netzwerk des Oszillatorverstärkers (16) auf Grundlage der von dem Temperaturfühler (18) bestimmten Temperatur des Oszillatorverstärkers (16) über den Steilheitsverstärker (36) so steuerbar ist, dass temperaturbedingte Variationen der Oszillatoreigenschaften zumindest teilweise kompensierbar sind.

2. Näherungsschalter nach Anspruch 1,
**dadurch gekennzeichnet,**
**dass** das durch das Target beeinflussbare Rückkoppelnetzwerk (15) im Mitkopplungszweig und das steuerbare Netzwerk im Gegenkopplungszweig des Verstärkerbausteins (21) vorgesehen ist.

3. Näherungsschalter nach Anspruch 1,
dadurch **gekennzeichet,**
dass das durch das Target beeinflussbare Rückkoppelnetzwerk (15) im Gegenkopplungszweig und das steuerbare Netzwerk im Mitkopplungszweig des Verstärkerbausteins (21) vorgesehen ist.

4. Näherungsschalter nach einem der Ansprüche 1 bis 3,
**dadurch gekennzeichnet,**
**dass** der Steilheitsverstärker mittels einer Steuerspannung oder eines Steuerstroms steuerbar ist.

5. Näherungsschalter nach einem der Ansprüche 1 bis 4,
**dadurch gekennzeichnet,**
**dass** das Rückkopplungsnetzwerk (15) eine bifilare Spule mit einer ersten und einer zweiten Wicklung (22, 24) aufweist, wobei die erste Wicklung (22) und die zweite Wicklung (24) aus Mehrfach-Litzen mit unterschiedlicher Litzenzahl und unterschiedlichen Litzendrahtdicken gebildet sind.

6. Näherungsschalter nach Anspruch 5
**dadurch gekennzeichnet,**
**dass** die erste Wicklung (22) aus einem Einzeldraht und die zweite Wicklung (24) aus einer Mehrfach-Litze gebildet ist.

7. Näherungsschalter nach einem der Ansprüche 5 oder 6,
**dadurch gekennzeichnet,**
**dass** der Einzeldraht oder die Litzendrähte der ersten Wicklung (22) einen größeren Querschnitt aufweisen als die Litzendrähte der Mehrfach-Litze der zweiten Wicklung (24).

8. Näherungsschalter nach einem der Ansprüche 5 bis 7,
**dadurch gekennzeichnet,**
**dass** die Dicke des Einzeldrahts der ersten Wicklung (22) zwischen 60 und 100 µm, bevorzugt etwa 70 µm, beträgt.

9. Näherungsschalternach einem der Ansprüche 5 bis 8,
**dadurch gekennzeichnet,**
**dass** die Dicke der Einzeldrähte der Mehrfach-Litze der zweiten Wicklung (24) zwischen 20 und 50 µm, bevorzugt etwa 30 µm, beträgt.

10. Näherungsschalter nach einem der Ansprüche 1 bis 9,
**dadurch gekennzeichnet,**
**dass** dem Oszillatorverstärker (16) ein Gleichrichter (32) und ein Komparator (34) mit fester Schaltschwelle nachgeschaltet sind.

11. Näherungsschalter nach einem der Ansprüche 1 bis 10,
**dadurch gekennzeichnet,**
**dass** das Rückkoppelnetzwerk (15) zur Einkopplung der Ausgangsspannung des Oszillatorverstärkers (16) eine Koppelkapazität (26) sowie einen ohmschen Widerstand (28) aufweist.

12. Näherungsschalter nach einem der Ansprüche 1 bis 11,
**dadurch gekennzeichnet,**
**dass** als Temperaturfühler (18) ein NTC-Netzwerk (19) vorgesehen ist.

13. Näherungsschalter nach einem der Ansprüche 10 bis 12,
**dadurch gekennzeichnet,**
**dass** ein Ausgang des Gleichrichters (32) mit dem Verstärkerbaustein (21) verbunden ist zur aussteuerungsabhängigen Veränderung der Verstärkung.

14. Verfahren zum Betrieb eines Näherungsschalters, insbesondere eines induktiven Näherungsschalters, insbesondere nach einem der Ansprüche 1 bis 13,
mit einem Oszillator (12), der ein durch ein zu detektierendes Target beeinflussbares, wenigstens teilweise eigenkompensiertes Rückkopplungsnetzwerk (15) und einen Oszillatorverstärker (16) aufweist, wobei der Oszillatorverstärker (16) einen Verstärkerbaustein (21) mit einem steuerbaren Netzwerk aufweist und wobei das steuerbare Netzwerk ein passives Kopplungsnetzwerk aufweist,
**dadurch gekennzeichnet,**
**dass** mit einem Temperaturfühler (18) eine Temperatur des Oszillatorverstärkers (16) bestimmt wird,
**dass** eine Übertragungsfunktion des steuerbaren Netzwerks mit einem steuerbaren Steilheitsverstärker (36) gesteuert wird,
wobei ein von einem Ausgangssignal des Temperaturfühlers (18) abgeleitetes Signal als Steuersignal für den Steilheitsverstärker (36) dient, und
**dass** die Übertragungsfunktion des Netzwerks in Abhängigkeit zumindest von der von dem Temperaturfühler (18) gemessenen Temperatur des Oszillatorverstärkers (16) mittels Verstärkungsvariation am Steilheitsverstärker (36) so gesteuert wird, dass temperaturbedingte Variationen des Oszillators (12) wenigstens teilweise kompensiert werden.

15. Verfahren nach Anspruch 14,
**dadurch gekennzeichnet,**
**dass** bei drei Temperaturen ein Abgleich der Verstärkung des Oszillatorverstärkers vorgenommen wird und
**dass** zwischen diesen drei Temperaturen eine Interpolation durchgeführt wird.

16. Verfahren nach Anspruch 14 oder 15,
**dadurch gekennzeichnet,**
**dass** die Verstärkung des Oszillatorverstärkers (16) aussteuerungsabhängig verändert wird, um ein schnelles Aufschwingen des Oszillators (12) zu ermöglichen.

## Claims

1. Proximity switch, particularly inductive proximity switch,
with an oscillator (12) having an at least partly self-compensated feedback network (15) influencible by a target to be detected, and an oscillator amplifier (16), wherein the oscillator amplifier (16) having an amplifier component (21) and a controllable network for controlling the gain of oscillator amplifier (16) and wherein the controllable network has a passive coupling network, particularly a negative feedback network (38),
**characterized in**
**that** there is a controllable transconductance amplifier (36) for controlling a transfer function of the controllable network,
**that** a temperature sensor (18) is provided for determing the temperature of the oscillator amplifier (16), in which a signal derived from an output signal of the temperature sensor (18) is used as the control signal for the transconductance amplifier (36), and
**that**, on the basis of the temperature determined by the temperature sensor (18), the controllable network of the oscillator amplifier (16) is controllable via the transconductance amplifier (36) in such a way that temperature-dependent variations of the oscillator characteristics are at least partly compensatable.

2. Proximity switch according to claim 1,
**characterized in**
**that** the feedback network (15) influencible by the target is provided in the positive feedback branch and the controllable network in the negative feedback branch of the amplifier component (21).

3. Proximity switch according to claim 1,
**characterized in**
**that** the feedback network (15) influencible by the target is provided in the negative feedback branch and the controllable network in the positive feedback branch of the amplifier component (21).

4. Proximity switch according to one of the claims 1 to 3,
**characterized in**
**that** the transconductance amplifier is controllable by means of a control voltage or a control current.

5. Proximity switch according to one of the claims 1 to 4,
**characterized in**
**that** the feedback network (15) has a bifilar coil with a first and a second winding (22, 24), the first winding (22) and the second winding (24) being formed from multiple strands with different strand numbers and different strand wire thicknesses.

6. Proximity switch according to claim 5,
**characterized in**
**that** the first winding (22) is formed by a single wire and the second winding (24) by a multiple strand.

7. Proximity switch according to claim 5 or 6,
**characterized in**
**that** the single wire or stranded wires of the first winding (22) have a larger cross-section than the stranded wires of the multiple strand of the second winding (24).

8. Proximity switch according to one of the claims 5 to 7,
**characterized in**
**that** the thickness of the single wire of the first winding (22) is between 60 and 100 µm, preferably approximately 70 µm.

9. Proximity switch according to one of the claims 5 to 8,
**characterized in**
**that** the thickness of the single wires of the multiple strand of the second winding (24) is between 20 and 50 µm, preferably approximately 30 µm.

10. Proximity switch according to one of the claims 1 to 9,
**characterized in**
**that** a rectifier (32) and a comparator (34) with fixed switching threshold are connected in series behind the oscillator amplifier (16).

11. Proximity switch according to one of the claims 1 to 10,
**characterized in**
**that** the feedback network (15) has a coupling capacitor (26) for coupling in the output voltage of oscillator amplifier (16), as well as an ohmic resistor (28).

12. Proximity switch according to one of the claims 1 to 11,
**characterized in**
**that** a NTC-network (19) is used as the temperature sensor (18).

13. Proximity switch according to one of the claims 10 to 12,
**characterized in**
**that** an output of the rectifier (32) is connected to the amplifier component (21) for the purpose of drive-dependent gain change.

14. Method for operating a proximity switch, particularly an inductive proximity switch, particularly according to one of the claims 1 to 13,
with an oscillator (12) having an at least partly self-compensated feedback network (15) influencible by a target to be detected, and an oscillator amplifier (16), wherein the oscillator amplifier (16) has an amplifier component (21) with a controllable network and wherein the controllable network has a passive coupling network
**characterized in**
**that** by means of a temperature sensor (18) a temperature of the oscillator amplifier (16) is determined,
**that** a transfer function of the controllable network is controlled by means of a controllable transconductance amplifier (36),
wherein a signal being derived from an output signal of the temperature sensor (18) is used as control signal for the transconductance amplifier (36), and that the transfer function of the network, in dependence of at least the temperature of the oscillator amplifier (16) measured by the temperature sensor (18), is controlled by means of a gain variation at the transconductance amplifier (36) in such a way that temperature-dependent variations of the oscillator (12) are at least partly compensated.

15. Method according to the claim 14,
**characterized in**
**that** at three temperatures an adjustment of the gain of the oscillator amplifier is carried out and
**that** an interpolation between these three temperatures is executed.

16. Method according to the claim 14 or 15,
**characterized in**
**that** the gain of the oscillator amplifier (16) is changed in a drive-dependent way for the purpose of enabling a quick rise of the oscillation of the oscillator (12).

## Revendications

1. Commutateur de proximité, plus particulièrement commutateur de proximité inductif,
avec un oscillateur (12), qui comprend un réseau de rétroaction (15), qui peut être influencé par une cible à détecter et qui est au moins en partie à compensation interne, et un amplificateur d'oscillateur (16),
dans lequel l'amplificateur d'oscillateur (16) comprend, pour la commande du gain de l'amplificateur d'oscillateur (16), un module amplificateur (21) et un réseau commandable, et
dans lequel le réseau commandable comprend un réseau de couplage passif, plus particulièrement un réseau de contre-réaction (38),
**caractérisé :**
**en ce qu'**un amplificateur de transconductance (36) est présent pour la commande d'une fonction de transfert du réseau commandable,
**en ce qu'**un capteur de température (18) est prévu pour la détermination de la température de l'amplificateur d'oscillateur (16), un signal dérivé d'un signal de sortie du capteur de température (18) étant alors utilisé comme signal de commande pour l'amplificateur de transconductance (36), et
**en ce que**, sur la base de la température de l'amplificateur d'oscillateur (16) déterminée par le capteur de température (18), le réseau commandable de l'amplificateur d'oscillateur (16) est commandable par l'intermédiaire de l'amplificateur de transconductance (36) de telle manière que des variations - liées à la température - des propriétés de l'oscillateur peuvent être, au moins en partie, compensées.

2. Commutateur de proximité selon la revendication 1,
**caractérisé :**
**en ce que** le réseau de rétroaction (15) pouvant être influencé par la cible est prévu dans la branche de couplage du module amplificateur (21), et le réseau commandable dans la branche de contre-réaction de ce dernier.

3. Commutateur de proximité selon la revendication 1,
**caractérisé :**
**en ce que** le réseau de rétroaction (15) pouvant être influencé par la cible est prévu dans la branche de contre-réaction du module amplificateur (21), et le réseau commandable dans la branche de couplage de ce dernier.

4. Commutateur de proximité selon une des revendications 1 à 3,
**caractérisé :**
**en ce que** l'amplificateur de transconductance est commandable au moyen d'une tension de commande ou d'un courant de commande.

5. Commutateur de proximité selon une des revendications 1 à 4,
**caractérisé :**
**en ce que** le réseau de rétroaction (15) comprend une bobine bifilaire avec un premier et un deuxième enroulement (22, 24), le premier enroulement (22) et
le deuxième enroulement (24) étant formés d'une pluralité de fils, avec des nombres de fils différents et des épaisseurs de fil différentes.

6. Commutateur de proximité selon la revendication 5,
**caractérisé :**
**en ce que** le premier enroulement (22) est formé d'un seul fil, et le deuxième enroulement (24) d'une pluralité de fils.

7. Commutateur de proximité selon une des revendications 5 ou 6,
**caractérisé :**
**en ce que** le fil unique ou les fils du premier enroulement (22) comprennent une section supérieure à celle des fils de la pluralité de fils du deuxième enroulement (24).

8. Commutateur de proximité selon une des revendications 5 à 7,
**caractérisé :**
**en ce que** l'épaisseur du fil unique du premier enroulement (22) a une valeur comprise entre 60 et 100 µm, de préférence environ 70 µm.

9. Commutateur de proximité selon une des revendications 5 à 8,
**caractérisé :**
**en ce que** l'épaisseur des fils individuels de la pluralité de fils du deuxième enroulement (24) a une valeur comprise entre 20 et 50 µm, de préférence environ 30 µm.

10. Commutateur de proximité selon une des revendications 1 à 9,
**caractérisé :**
**en ce qu'**un redresseur (32) et un comparateur (34) à seuil de commutation fixe sont raccordés à la suite de l'amplificateur d'oscillateur (16).

11. Commutateur de proximité selon une des revendications 1 à 10,
**caractérisé :**
**en ce que** le réseau de rétroaction (15) comprend, pour le couplage de la tension de sortie de l'amplificateur d'oscillateur (16), un condensateur de couplage (26) ainsi qu'une résistance ohmique (28).

12. Commutateur de proximité selon une des revendications 1 à 11,
**caractérisé :**
**en ce que**, comme capteur de température (18), un réseau à coefficient de température négatif (19) est prévu.

13. Commutateur de proximité selon une des revendications 10 à 12,
**caractérisé :**
**en ce qu'**une sortie du redresseur (32) est reliée au module amplificateur (21) pour la modification du gain en fonction de la modulation.

14. Procédé de fonctionnement d'un commutateur de proximité, et en particulier d'un commutateur de proximité inductif, plus particulièrement selon une des revendications 1 à 13,
avec un oscillateur (12), qui comprend un réseau de rétroaction (15), pouvant être influencé par une cible à détecter et étant au moins en partie à compensation interne, et un amplificateur d'oscillateur (16), l'amplificateur d'oscillateur (16) comprenant un module amplificateur (21) avec un réseau commandable et le réseau commandable comprenant un réseau de couplage passif,
**caractérisé :**
**en ce qu'**une température de l'amplificateur d'oscillateur (16) est déterminée avec un capteur de température (18),
**en ce qu'**une fonction de transfert du réseau commandable est commandée avec un amplificateur de transconductance (36) commandable,
un signal dérivé d'un signal de sortie du capteur de température (18) étant alors utilisé comme signal de commande pour l'amplificateur de transconductance (36), et
**en ce que**, en fonction au moins de la température de l'amplificateur d'oscillateur (16) mesurée par le capteur de température (18), la fonction de transfert du réseau est commandée au moyen d'une modification du gain sur l'amplificateur de transconductance (36) de telle manière que des variations - liées à la température - de l'oscillateur (12) sont, au moins en partie, compensées.

15. Procédé selon la revendication 14,
**caractérisé :**
**en ce qu'**une comparaison du gain de l'amplificateur d'oscillateur est effectuée pour trois températures, et
**en ce qu'**une interpolation est mise en oeuvre entre ces trois températures.

16. Procédé selon la revendication 14 ou 15,
**caractérisé :**
**en ce que** le gain de l'amplificateur d'oscillateur (16) est modifié en fonction de la modulation, pour permettre une oscillation rapide de l'oscillateur (12).
